# EUROPÄISCHE PATENTSCHRIFT

(11) **EP 1 191 541 B1**
(45) Veröffentlichungstag und Bekanntmachung des Hinweises auf die Patenterteilung: **11.02.2004**
(21) Anmeldenummer: 01127740.7
(22) Anmeldetag: 21.11.1996
(51) Int. Cl.: G11C 16/04

(54) **EEPROM und Verfahren zur Ansteuerung desselben**
EEPROM and method of controlling same
Mémoire EEPROM et procédé de commande correspondant

(30) Priorität: 06.12.1995 DE 19545523
(43) Veröffentlichungstag der Anmeldung: 27.03.2002
(62) Teilanmeldung aus: 96946005.4
(73) Patentinhaber: Infineon Technologies AG, 81669 München (DE)
(72) Erfinder: Sedlak, Holger, 85658 Egmating (DE)
(74) Vertreter: Epping Hermann & Fischer

(56) Entgegenhaltungen:
- EP-A- 0 387 889
- EP-A- 0 637 035
- DE-A- 4 233 248
- US-A- 5 033 023

## Beschreibung

Die vorliegende Erfindung betrifft ein EEPROM gemäß dem Oberbegriff des Patentanspruchs 1 und ein Verfahren zu dessen Ansteuerung desselben gemäß dem Oberbegriff des Patentanspruchs 14. Ein EEPROM mit den Merkmalen des Oberbegriffs des Patentanspruches 1 ist aus der EP 0 637 035 A1 bekannt.

EEPROMs und Verfahren zur Ansteuerung derselben zum Einschreiben, Auslesen und Löschen von Daten sind seit langem bekannt und werden in steigendem Maß verwendet.

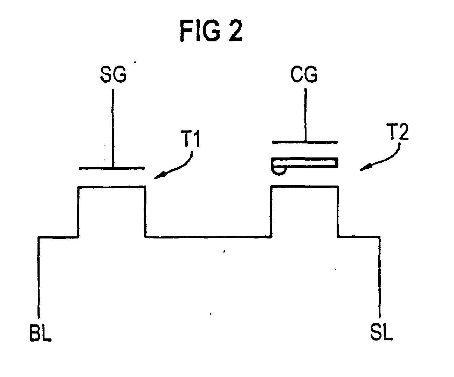

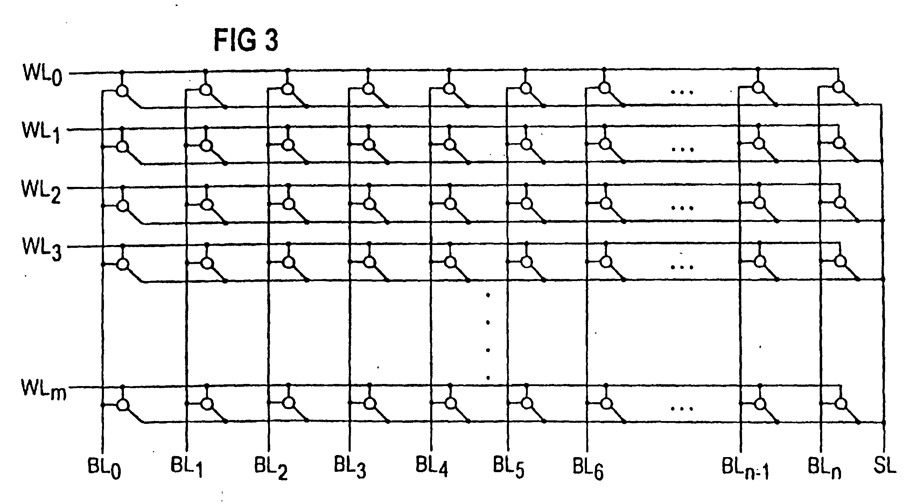

Ein praktisches Beispiel des Aufbaus und der Ansteuerung eines herkömmlichen EEPROM werden nachfolgend unter Bezugnahme auf die Figuren 2 und 3 erläutert.

Das beschriebene herkömmliche EEPROM weist eine Vielzahl von in einem Speicherzellenfeld angeordneten Speicherzellen auf, die mittels jeweiliger Wort-, Bit- und Sourceleitungen ansprechbar sind.

Ein beispielhafter Aufbau einer einzelnen Speicherzelle (zur Speicherung eines einzelnen Datenbits) ist in der Figur 2 dargestellt.

Die in der Figur 2 gezeigte Speicherzelle, weist einen Auswahltransistor T1 und einen Speichertransistor T2 auf.

Der Auswahltransistor T1 ist ein "normaler" Feldeffekttransistor, dessen Wirkungsweise und Funktion bekannt sind und keiner weiteren Erläuterung bedürfen.

Der Speichertransistor T2 ist ein ein floatendes (verbindungsloses) Gate mit einem Tunnelfenster aufweisender Feldeffekttransistor, dessen Wirkungsweise und Funktion aufgrund des weit verbreiteten Einsatzes in EEPROM-Speicherzellen ebenfalls bekannt sind und folglich auch keiner weiteren Erläuterung bedürfen.

Vom Auswahltransistor T1 ist der Sourceabschnitt mit einer Bitleitung BL, der Gateabschnitt mit einer Auswahlleitung SG, und der Drainabschnitt mit dem Drainabschnitt des Speichertransistors T2 verbunden.

Vom Speichertransistor T2 ist der Sourceabschnitt mit einer Sourceleitung SL, der Steuergateabschnitt mit einer Steuerleitung CG, und der Drainabschnitt mit dem Drainabschnitt des Auswahltransistors T1 verbunden.

Die Auswahlleitung SG und die Steuerleitung CG bilden gemeinsam eine sogenannte Wortleitung WL.

Die genannten Signalleitungen führen zum Lesen, Löschen und Schreiben die folgenden Signale, wobei Uₚₚ eine Hochspannung von beispielsweise ca. 15 V bis 20 V ist:

| | BL | SG | CG |
|---|---|---|---|
| Lesen | ≈ 4 V | 5 V | ≈ 1,2 V |
| Löschen | 0 V | Uₚₚ | Uₚₚ |
| Schreiben | Uₚₚ / 0 V | Uₚₚ | 0 V |

Die in der Figur 2 gezeigte Speicherzelle ist bei Vorsehen einer entsprechenden Anzahl derselben zu einem Speicherzellenfeld zusammensetzbar.

Der Aufbau eines derartigen Speicherzellenfeldes ist in Figur 3 dargestellt.

Figur 3 ist eine schematische Darstellung eines Speicherzellenfeldes eines herkömmlichen EEPROMs.

Das gezeigte Speicherzellenfeld weist eine Vielzahl von jeweils mit einem "O" gekennzeichneten einzelnen Speicherzellen gemäß Figur 2 auf, die in mehreren (m) Reihen und mehreren (n) Spalten angeordnet sind.

Die n Elemente einer jeden Speicherzellenfeldreihe sind jeweils mit einer gemeinsamen Wortleitung WL₀, WL₁ ... WLₘ (jeweils bestehend aus einer Auswahlleitung SG und einer Steuerleitung CG) verbunden. Die m Elemente einer jeden Speicherzellenfeldspalte sind jeweils mit einer gemeinsamen Bitleitung BL₀, BL₁ ... BLₙ verbunden. Die Sourceleitungen SL aller Speicherzellen des Speicherzellenfeldes sind zu einer gemeinsamen Sourceleitung zusammengefaßt.

Die Verschaltung der Speicherzellen zu dem in der Figur 3 gezeigten matrixartig aufgebauten Speicherzellenfeld ermöglicht es, die Speicherzellen durch entsprechende Ansteuerung der Wort-, Bit- und Sourceleitungen einzeln (beim Einschreiben und Auslesen von Daten) bzw. zeilenweise (beim Löschen von Daten) anzusprechen.

Derart aufgebaute EEPROMs werden zunehmend in Chipkarten eingesetzt, deren Speicherinhalt bei bestimmten Anlässen entsprechend zwischenzeitlichen Veränderungen aktualisiert werden muß (beispielsweise der Gebührenzähler einer Telefonkarte). Derartige Aktualisierungen erfordern ein Löschen und ein anschließendes Überschreiben von Speicherbereichen des EEPROM.

Der hierfür zu treibende Aufwand ist insbesondere in dem sehr häufigen Fall, daß nur geringe Datenmengen zu aktualisieren sind, unverhältnismäßig hoch und läßt es, sofern nicht zusätzliche Sicherheitsvorkehrungen getroffen werden, nicht gänzlich ausschließen, daß die gewünschte Aktualisierung bei einem unglücklichen Zusammentreffen seltener Ausnahmezustände unter Umständen nicht bestimmungsgemäß ausgeführt wird.

Der vorliegenden Erfindung liegt daher die Aufgabe zugrunde, ein EEPROM gemäß dem Oberbegriff des Patentanspruchs 1 und ein Verfahren zur Ansteuerung desselben gemäß dem Oberbegriff des Patentanspruchs 14 derart weiterzubilden, daß die Aktualisierung gespeicherter Daten stets einfach, angemessen schnell und weitestgehend störungsunanfällig durchführbar ist.

Diese Aufgabe wird erfindungsgemäß durch die im kennzeichnenden Teil des Patentanspruchs 1 bzw. die im kennzeichnenden Teil des Patentanspruchs 14 beanspruchten Merkmale gelöst.

Demnach ist vorgesehen, die über eine einzelne Wortleitung ansprechbaren Speicherzellen in eine Vielzahl unterschiedlich großer Gruppen aufzuteilen, von denen jeder eine separate gemeinsame Sourceleitung zugeordnet ist (Patentanspruch 1) bzw. ein gruppenweises Beschreiben, Auslesen und/oder Löschen der über eine einzelne Wortleitung ansprechbaren Speicherzellen durchzuführen (Patentanspruch 14).

Diese Maßnahmen ermöglichen es, ein Einschreiben, Auslesen und vor allem auch ein Löschen von Daten selektiv auf ganz bestimmte Daten zu beschränken, was bisher aufgrund des Vorsehens von nur einer einzigen gemeinsamen Sourceleitung für alle Speicherzellen des Speicherzellenfeldes zumindest beim Löschen nicht möglich war (das Löschen konnte nur zeilenweise erfolgen).

Das Aktualisieren von Daten, was durch ein Löschen der zu aktualisierenden Daten und ein sich daran anschließendes Überschreiben durch die aktualisierten Daten geschieht, kann mithin unter ausschließlichem Zugriff auf die zu aktualisierenden Daten durchgeführt werden.

D.h., durch Vorsehen der erfindungsgemäßen Maßnahmen kann im Gegensatz zu den bislang zur Aktualisierung von Daten durchzuführenden Schritten, nämlich
(1) komplettes Umspeichern des Inhalts der durch eine Wortleitung ansprechbaren Speicherzellen (Speicherzellenfeldreihe),
(2) Löschen der in der Speicherzellenfeldreihe gespeicherten Daten, und
(3) Zurückschreiben der nicht zu aktualisierenden Daten und Neueinschreiben der zu aktualisierenden Daten in die gelöschte Speicherzellenfeldreihe,
auf ein Umspeichern, Löschen und Zurückschreiben der nicht zu aktualisierenden Daten verzichtet werden.

Der Wegfall dieser zusätzlichen Vorgänge verhindert beispielsweise zuverlässig, daß bei einer Unterbrechung der Stromversorgung vorübergehend gelöschte Daten (auf einen vorbestimmten Löschwert wie "0000..." oder "1111..." gesetzte Daten) anstelle von nicht zu aktualisierenden Daten im EEPROM stehen bleiben.

Die Aktualisierung von Daten ist darüber hinaus aufgrund der verringerten Anzahl von Lese-, Schreib- und Löschoperationen schneller und unter geringerem Energieeinsatz durchführbar.

Die verringerte Anzahl von Schreibvorgängen erhöht ferner die Lebensdauer der nur eine beschränkte Anzahl von Schreibvorgängen (endurance) verkraftenden Speicherzellen.

Vorteilhafte Weiterbildungen der Erfindung sind Gegenstand der Unteransprüche.

Die Erfindung wird nachfolgend anhand eines Ausführungsbeispiels unter Bezugnahme auf die Zeichnungen näher erläutert.
Es zeigen:
Figur 1 eine schematische Darstellung eines Ausführungsbeispiels des Aufbaus des Speicherzellenfeldes eines erfindungsgemäß ausgebildeten EEPROM,
Figur 2 eine schematische Darstellung des Aufbaus einer EEPROM-Speicherzelle, und
Figur 3 eine schematische Darstellung des Aufbaus eines herkömmlichen EEPROM-Speicherzellenfeldes.

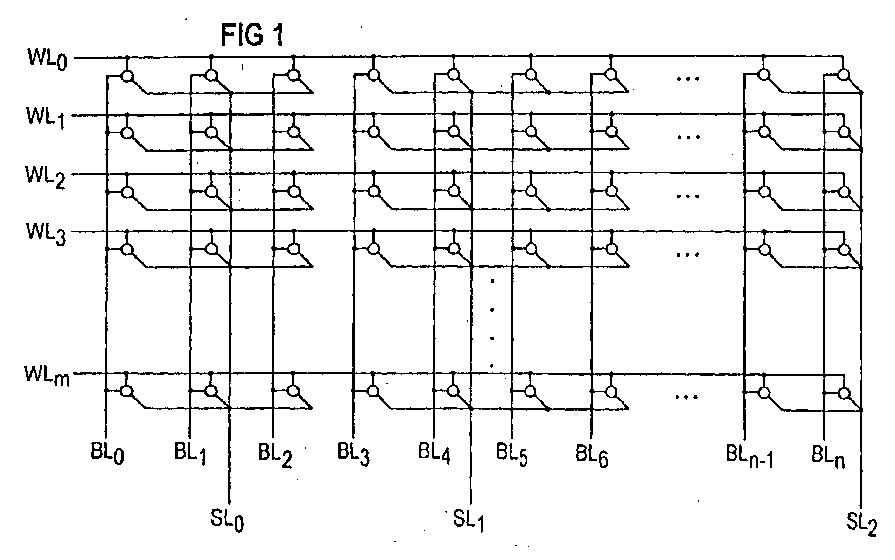

Das in Figur 1 gezeigte Speicherzellenfeld besteht wie das in Figur 3 gezeigte herkömmliche Speicherzellenfeld aus einer Vielzahl von jeweils durch das Symbol "O" gekennzeichneten herkömmlichen Speicherzellen (beispielsweise Speicherzellen der in der Figur 2 gezeigten Art), die in einer Vielzahl (m) von Reihen und einer Vielzahl (n) von Spalten angeordnet sind.

Die n Elemente jeder Speicherzellenfeldreihe sind jeweils mit einer gemeinsamen Wortleitung WL₀, WL₁, ... WLₘ (jeweils bestehend aus einer Auswahlleitung SG und einer Steuerleitung CG) verbunden. Die m Elemente jeder Speicherzellenfeldspalte sind jeweils mit einer gemeinsamen Bitleitung BL₀, BL₁ ... BLₙ verbunden.

Im Gegensatz zu dem in Figur 3 gezeigten herkömmlichen Speicherzellenfeld sind jedoch die Sourceleitungen der Speicherzellen nicht mehr zu einer für alle Speicherzellen des Speicherzellenfeldes gemeinsamen Sourceleitung zusammengefaßt.

Es ist vielmehr eine beliebige Vielzahl von separaten Sourceleitungen SL vorgesehen (in der Figur 1 sind beispielhaft SL₀, SL₁ und SL₂ gezeigt), von denen jede einer bestimmten Gruppe von Speicherzellen innerhalb einer Speicherzellenfeldreihe zugeordnet ist. Anders ausgedrückt sind die Speicherzellen einer Speicherzellenfeldreihe in mehrere Gruppen aufgeteilt, von denen jede eine separate, aber für die Speicherzellen einer jeweiligen Gruppe gemeinsame Sourceleitung aufweist.

In der Regel wird eine Speicherzellengruppe in der Praxis so viele Speicherzellen enthalten wie ein Datenwort (beispielsweise ein Byte) Bits aufweist, und es wird pro Speicherzellenfeldreihe eine Vielzahl derartiger identischer Speicherzellengruppen nebeneinanderliegend (aneinander gereiht) vorgesehen sein.

Allgemein gesprochen kann jedoch jede Speicherzellenfeldreihe je nach Bedarf eine beliebige Vielzahl von Gruppen (mindestens zwei) aufweisen, welche gleich oder unterschiedlich groß sein können, eine beliebige Anzahl von Speicherzellen (mindestens eine) umfassen können, und deren einzelne Elemente bzw. Speicherzellen beliebig über die Speicherzellenfeldreihe verteilt sein können.

Eine der sich daraus ergebenden, vom genannten Regelfall abweichenden Möglichkeiten besteht darin, die Speicherzellen jedes x-ten Datenwortes innerhalb einer Speicherzellenfeldreihe zu einer Gruppe zusammenzufassen (um beispielsweise die jedem Zeichen eines anzuzeigenden Textes zugeordneten Anzeigeattribute gemeinsam verändern zu können).

In der Darstellung der Figur 1 sind drei Speicherzellengruppen eingezeichnet. Die erste (gemäß Figur 1 linke) Gruppe besteht aus drei nebeneinander liegenden Speicherzellen, deren Sourceleitungen zu einer separaten gemeinsamen Sourceleitung SL₀ zusammengefaßt sind. Die sich daran anschließende zweite (gemäß Figur 1 mittlere) Gruppe besteht aus vier nebeneinander liegenden Speicherzellen, deren Sourceleitungen zu einer separaten gemeinsamen Sourceleitung SL₁ zusammengefaßt sind. Die dritte (gemäß Figur 1 rechte) Gruppe besteht aus zwei nebeneinander liegenden Speicherzellen, deren Sourceleitungen zu einer separaten gemeinsamen Sourceleitung SL₂ zusammengefaßt sind.

Die Gruppeneinteilung ist im gezeigten Ausführungsbeispiel für alle Speicherzellenfeldreihen gleich. Die jeweiligen gemeinsamen Sourceleitungen der einander entsprechenden Gruppen in verschiedenen Speicherzellenfeldreihen sind miteinander verbunden. Ein derartiger Aufbau begrenzt zwar den zur Speicherzellenfeldrealisierung erforderlichen Aufwand, ist aber selbstverständlich nicht zwingend. Es kann vielmehr jede Speicherzellenfeldreihe völlig unabhängig von den anderen Reihen beliebig unterteilt werden, und die Sourceleitungen der jeweiligen Gruppen können völlig unabhängig voneinander verlegt und angesteuert werden.

Die beschriebene Gestaltung des EEPROM-Speicherzellenfeldes ermöglicht (unter Verwendung einer entsprechenden Steuervorrichtung) ein gruppenweises Beschreiben, Auslesen und/oder Löschen der über eine einzelne Wortleitung ansprechbaren Speicherzellen, wobei eine Gruppe, wie vorstehend bereits angedeutet im Extremfall auch nur aus einer einzigen Speicherzelle bestehen kann.

Die einzelnen Speicherzellen des EEPROM-Speicherzellen sind damit selektiv in einer beliebigen Anzahl und Verteilung zum Einschreiben, Auslesen und Löschen von Daten ansprechbar.

Dies wirkt sich insbesondere beim Löschen von Daten und beim Aktualisieren (= Löschen + Neueinschreiben) von Daten vorteilhaft aus, denn bei herkömmlichen Speicherzellenfeldern war, wie eingangs bereits erwähnt, das Löschen nur in (unter Umständen sehr großen) Einheiten von Speicherzellenfeldreihen möglich.

Ein selektives Löschen einer einzelnen Gruppe innerhalb einer Speicherzellenfeldreihe erfolgt dadurch, daß die Bitleitung(en) BL der Speicherzellen der zu löschenden Gruppe mit 0 V beaufschlagt werden, und daß die Auswahlleitung SG und die Steuerleitung CG der betreffenden Gruppe jeweils mit einer Hochspannung von beispielsweise +15 bis +20 V beaufschlagt werden.

Ein Nicht-Löschen der restlichen Gruppe innerhalb der betreffenden Speicherzellenfeldreihe erfolgt dadurch, daß bei ansonsten identischen Bedingungen die Bitleitung(en) BL der Speicherzellen der nicht zu löschenden Gruppe(n) ebenfalls mit einer Hochspannung von beispielsweise +15 bis +20 V beaufschlagt werden.

Die jeweiligen Sourceleitungen der Speicherzellengruppen werden dabei selektiv in floatendem (nicht aktiv getriebenem) Zustand gehalten (wenn an die zugeordneten Bitleitungen wie beim Nicht-Löschen eine aktiv getriebene Hochspannung angelegt wird) oder mit Masse verbunden (in allen anderen Fällen).

Die Vorgänge beim Einschreiben und Auslesen von Daten bedürfen keiner Anpassung an den erfindungsgemäßen EEPROM-Aufbau. Gleichwohl eröffnet der neuartige Aufbau Möglichkeiten, auch diese Vorgänge in vorteilhafter Weise zu modifizieren.

Um zuverlässig zu verhindern, daß durch das Beaufschlagen der verschiedenen Signalleitungen mit Hochspannung eine möglicherweise zu einer Datenveränderung führende Ladungsakkumulation in den Speicherzellen erfolgt, kann vorgesehen werden, die Hochspannung nicht sofort in voller Höhe anzulegen, sondern sie nur allmählich (stufenweise und/oder rampenfömig) auf den Sollwert steigend anzulegen.

## Patentansprüche

1. EEPROM mit einer Vielzahl von in einem Speicherzellenfeld angeordneten Speicherzellen, die mittels Wort-, Bit- und Sourceleitungen (WL, BL, SL) zum Beschreiben, Auslesen und Löschen ansprechbar sind, wobei die über eine einzelne Wortleitung (WL) ansprechbaren Speicherzellen in eine Vielzahl von Gruppen aufgeteilt sind, von denen jeder eine separate gemeinsame Sourceleitung (SL) zugeordnet ist,
**dadurch gekennzeichnet, daß**
die Speicherzellengruppen einer Speicherzellenfeldreihe unterschiedlich groß sind.

2. EEPROM nach Anspruch 1,
**dadurch gekennzeichnet,**
**daß** sich die Wortleitungen (WL) jeweils aus einer Auswahlleitung (SG) und einer Steuerleitung (CG) zusammensetzen.

3. EEPROM nach Anspruch 1 oder 2,
**dadurch gekennzeichnet,**
**daß** die Speicherzellen jeweils aus einem Auswahltransistor (T1) und einem Speichertransistor (T2) bestehen, deren Drainabschnitte miteinander verbunden sind.

4. EEPROM nach Anspruch 3,
**dadurch gekennzeichnet,**
**daß** die Gateabschnitte der Auswahltransistoren (T1) jeweils mit einer der Auswahlleitungen (SG) verbunden sind.

5. EEPROM nach Anspruch 3 oder 4,
**dadurch gekennzeichnet,**
**daß** die Sourceabschnitte der Auswahltransistoren (T1) jeweils mit einer der Bitleitungen (BL) verbunden sind.

6. EEPROM nach einem der Ansprüche 3 bis 5,
**dadurch gekennzeichnet,**
**daß** die Steuergateabschnitte der Speichertransistoren (T2) jeweils mit einer der Steuerleitungen (CG) verbunden sind.

7. EEPROM nach einem der Ansprüche 3 bis 6,
**dadurch gekennzeichnet,**
**daß** die Sourceabschnitte der Speichertransistoren (T2) jeweils mit einer der Sourceleitungen (SL) verbunden sind.

8. EEPROM nach einem der Ansprüche 2 bis 7,
**dadurch gekennzeichnet,**
**daß** in der selben Reihe des Speicherzellenfeldes vorgesehene Speicherzellen jeweils mit den selben Auswahl- und Steuerleitungen (SG, CG) verbunden sind.

9. EEPROM nach einem der vorhergehenden Ansprüche,
**dadurch gekennzeichnet,**
**daß** in der selben Spalte des Speicherzellenfeldes vorgesehene Speicherzellen jeweils mit der selben Bitleitung (BL) verbunden sind.

10. EEPROM nach einem der vorhergehenden Ansprüche,
**dadurch gekennzeichnet,**
**daß** in der selben Spalte des Speicherzellenfeldes vorgesehene Speicherzellen jeweils mit der selben Sourceleitung (SL) verbunden sind.

11. EEPROM nach einem der vorhergehenden Ansprüche,
**dadurch gekennzeichnet,**
**daß** eine Speicherzelle zur Speicherung eines Datenbits ausgelegt ist.

12. EEPROM nach einem der vorhergehenden Ansprüche,
**dadurch gekennzeichnet,**
**daß** eine Speicherzellengruppe zu Speicherung eines aus beliebig vielen Datenbits bestehenden Datenworts ausgelegt ist.

13. EEPROM nach Anspruch 12,
**dadurch gekennzeichnet,**
**daß** das Datenwort ein Datenbyte ist.

14. Verfahren zur Ansteuerung eines EEPROM nach einem der Ansprüche 1 bis 13, bei dem die
über eine einzelne Wortleitung (WL) ansprechbaren Speicherzellen gruppenweise beschrieben, ausgelesen und/oder gelöscht werden,
**dadurch gekennzeichnet,**
**daß** mehrere Speicherzellengruppen als eine gemeinsame Gruppe behandelt werden.

15. Verfahren nach Anspruch 14,
**dadurch gekennzeichnet,**
**daß** zum Löschen der Daten einer Speicherzellengruppe im wesentlichen 0 V an die jeweiligen Bitleitungen (BL) der zu löschenden Speicherzellengruppe, sowie eine Hochspannung (Uₚₚ) an die betreffende Auswahlleitung (SG) und Steuerleitung (CG) angelegt werden.

16. Verfahren nach Anspruch 15,
**dadurch gekennzeichnet,**
**daß** die Sourceleitung (SL) einer zu löschenden Speicherzellengruppe im wesentlichen auf Masse gelegt wird.

17. Verfahren nach Anspruch 15 oder 16,
**dadurch gekennzeichnet,**
**daß** zum Nicht-Löschen der Daten nicht zu löschender Speicherzellengruppen eine Hochspannung (Uₚₚ) an die Bitleitungen (BL) der nicht zu löschenden Speicherzellengruppe angelegt wird.

18. Verfahren nach Anspruch 17,
**dadurch gekennzeichnet,**
**daß** die Sourceleitung (SL) einer nicht zu löschenden Speicherzellengruppe floatend gehalten wird.

19. Verfahren nach einem der Ansprüche 14 bis 18,
**dadurch gekennzeichnet,**
**daß** die bei Bedarf an jeweilige Signalleitungen einer Speicherzellengruppe anzulegende Hochspannung (Upp) insbesondere beim selektiven Löschen nach deren Anlegen erst allmählich auf ihren Sollwert erhöht wird.

20. Verfahren nach Anspruch 19,
**dadurch gekennzeichnet,**
**daß** der Anstieg stufen- und/oder rampenförmig erfolgt.

## Claims

1. EEPROM having a multiplicity of memory cells which are arranged in a memory cell array and can be addressed by means of word, bit and source lines (WL, BL, SL) for writing, reading out and erasing, the memory cells which can be addressed via a single word line (WL) being divided up into a multiplicity of groups, of which each is assigned a separate common source line (SL), **characterized in that** the memory cell groups of a row of the memory cell array are of different sizes.

2. EEPROM according to Claim 1, **characterized in that** the word lines (WL) are in each case made up of a selection line (SG) and a control line (CG).

3. EEPROM according to Claim 1 or 2, **characterized in that** the memory cells in each case comprise a selection transistor (T1) and a memory transistor (T2), the drain portions of which are connected to each other.

4. EEPROM according to Claim 3, **characterized in that** the gate portions of the selection transistors (T1) are in each case connected to one of the selection lines (SG).

5. EEPROM according to Claim 3 or 4, **characterized in that** the source portions of the selection transistors (T1) are in each case connected to one of the bit lines (BL).

6. EEPROM according to one of Claims 3 to 5, **characterized in that** the control gate portions of the memory transistors (T2) are in each case connected to one of the control lines (CG).

7. EEPROM according to one of Claims 3 to 6, **characterized in that** the source portions of the memory transistors (T2) are in each case connected to one of the source lines (SL).

8. EEPROM according to one of Claims 2 to 7, **characterized in that** memory cells provided in the same row of the memory cell array are in each case connected to the same selection and control lines (SG, CG).

9. EEPROM according to one of the preceding claims, **characterized in that** memory cells provided in the same column of the memory cell array are in each case connected to the same bit line (BL).

10. EEPROM according to one of the preceding claims, **characterized in that** memory cells provided in the same column of the memory cell array are in each case connected to the same source line (SL).

11. EEPROM according to one of the preceding claims, **characterized in that** a memory cell is designed for storing a data bit.

12. EEPROM according to one of the preceding claims, **characterized in that** a memory cell group is designed for storing a data word comprising any desired number of data bits.

13. EEPROM according to Claim 12, **characterized in that** a data word is a data byte.

14. Method of driving an EEPROM according to one of Claims 1 to 13, in which the memory cells which can be addressed via a single word line (WL) are written to, read from and/or erased group by group, **characterized in that** a plurality of memory cell groups are handled as a common group.

15. Method according to Claim 14, **characterized in that**, for erasing the data of a memory cell group, essentially 0 V is applied to the respective bit lines (BL) of the memory cell group to be erased, and a high voltage (Uₚₚ) is applied to the selection line (SG) and control line (CG) concerned.

16. Method according to Claim 15, **characterized in that** the source line (SL) of a memory cell group to be erased is connected essentially to earth.

17. Method according to Claim 15 or 16, **characterized in that**, for the non-erasing of the data of memory cell groups not to be erased, a high voltage (Uₚₚ) is applied to the bit lines (BL) of the memory cell group not to be erased.

18. Method according to Claim 17, **characterized in that** the source line (SL) of a memory cell group not to be erased is kept floating.

19. Method according to one of Claims 14 to 18, **characterized in that** the high voltage (Uₚₚ) to be applied, if required, to respective signal lines of a memory cell group is, once it has been applied, at first increased gradually to its set value, in particular in the case of selective erasing.

20. Method according to Claim 19, **characterized in that** the increase takes place in step and/or ramp form.

## Revendications

1. EEPROM ayant une pluralité de cellules de mémoire disposées dans un champ de cellules de mémoire et pouvant être adressées au moyen de lignes (WL, BL, SL) de mots, de bits et de sources pour l'écriture, la lecture et l'effacement, les cellules de mémoire pouvant être adressées par une ligne (WL) individuelle de mots étant réparties en une pluralité de groupes à chacun desquels est affectée une ligne (SL) commune de sources distincte, **caractérisée en ce que** les groupes de cellules de mémoire d'une rangée du champ de cellules de mémoire sont de dimensions différentes.

2. EEPROM suivant la revendication 1, **caractérisée en ce que** les lignes (WL) de mots sont composées, respectivement, d'une ligne (SG) de sélection et d'une ligne (CG) de commande.

3. EEPROM suivant la revendication 1 ou 2, **caractérisée en ce que** les cellules de mémoire sont constituées, respectivement, d'un transistor (T1) de sélection et d'un transistor (T2) de mémoire, dont les parties de drain sont reliées entre elles.

4. EEPROM suivant la revendication 3, **caractérisée en ce que** les parties de grille des transistors (T1) de sélection sont reliées, respectivement, à l'une des lignes (SG) de sélection.

5. EEPROM suivant la revendication 3 ou 4, **caractérisée en ce que** les parties de sources des transistors (T1) de sélection sont reliées, respectivement, à l'une des lignes (BL) de bits.

6. EEPROM suivant l'une des revendications 3 à 6, **caractérisée en ce que** les parties de grille de commande des transistors (T2) de mémoire sont reliées, respectivement, à l'une des lignes (CG) de commande.

7. EEPROM suivant l'une des revendications 3 à 6, **caractérisée en ce que** les parties de sources des transistors (T2) de mémoire sont reliées, respectivement, à l'une des lignes (SL) de sources.

8. EEPROM suivant l'une des revendications 2 à 7, **caractérisée en ce que** des cellules de mémoire prévues dans la même rangée du champ de cellules de mémoire sont reliées, respectivement, aux mêmes lignes (SG, CG) de sélection et de commande.

9. EEPROM suivant l'une des revendications précédentes, **caractérisée en ce que** des cellules de mémoire prévues dans la même colonne du champ de cellules de mémoire sont reliées, respectivement, à la même ligne (BL) de bits.

10. EEPROM suivant l'une des revendications précédentes, **caractérisée en ce que** les cellules de mémoire prévues dans la même colonne du champ de cellules de mémoire sont reliées, respectivement, à la même ligne (SL) de sources.

11. EEPROM suivant l'une des revendications précédentes, **caractérisée en ce qu'**une cellule de mémoire est conçue pour la mémorisation d'un bit de données.

12. EEPROM suivant l'une des revendications précédentes, **caractérisée en ce qu'**un groupe de cellules de mémoire est conçu pour la mémorisation d'un mot de données constitué de n'importe quel nombre de bits de données.

13. EEPROM suivant la revendication 12, **caractérisée en ce que** le mot de données est un octet de données.

14. Procédé de commande d'une EEPROM suivant l'une des revendications 1 à 13, dans lequel
on écrit, lit et/ou efface groupe par groupe des cellules de mémoire pouvant être adressées par une ligne (WL) individuelle de mots,
**caractérisé**
**en ce que** l'on traite plusieurs groupes de cellules de mémoire comme un groupe commun.

15. Procédé suivant la revendication 14, **caractérisé en ce que**, pour effacer les données d'un groupe de cellules de mémoire, on applique sensiblement 0 V aux lignes (BL) respectives de bits du groupe de cellules de mémoire à effacer, ainsi qu'une haute tension (Uₚₚ) à la ligne (SG) de sélection concernée et à la ligne (CG) de commande concernée.

16. Procédé suivant la revendication 15, **caractérisé en ce que** l'on met sensiblement à la masse la ligne (SL) de sources d'un groupe de cellules de mémoire à effacer.

17. Procédé suivant la revendication 15 ou 16, **caractérisé en ce que**, pour ne pas effacer des données de groupes de cellules de mémoire qui ne doivent pas être effacées, on applique une haute tension (Uₚₚ) aux lignes (BL) de bits du groupe de cellules de mémoire qui ne doivent pas être effacées.

18. Procédé suivant la revendication 17, **caractérisé en ce qu'**on maintient flottante la ligne (SL) de sources d'un groupe de cellules de mémoire qui ne doivent pas être effacées.

19. Procédé suivant l'une des revendications 14 à 18, **caractérisé en ce que** l'on porte la haute tension (Uₚₚ) à appliquer en cas de besoin aux lignes respectives de signal d'un groupe de cellules de mémoire, notamment lors de l'effacement selectif après son application, seulement peu à peu à sa valeur de consigne.

20. Procédé suivant la revendication 19, **caractérisé en ce que** l'elevation s'ettectue par degre et/ou sous forme ae rampe.
